# EUROPEAN PATENT SPECIFICATION

(11) **EP 2 124 336 B1**
(45) Date of publication and mention of the grant of the patent: **11.07.2012**
(21) Application number: 08156863.6
(22) Date of filing: 23.05.2008
(51) Int. Cl.: H03K 3/356

(54) **High-speed latched comparator circuit**
Gelatchte Hochgeschwindigkeits-Komparatorschaltung
Circuit comparateur verrouillé haute vitesse

(43) Date of publication of application: 25.11.2009
(73) Proprietor: Zoran Corporation, Sunnyvale, CA 94086 (US)
(72) Inventor: Jansson, Christer, 585 98, Linköping (SE)
(74) Representative: Andersson, Björn E.

(56) References cited:
- US-A- 5 486 785

## Description

### Technical Field

The present invention relates to a latched comparator circuit.

### Background

Latched comparator circuits are used in various types of electronic circuitry, e.g. for comparing two input voltages. For example, in an analog-to-digital converter (ADC), one or more latched comparators may be utilized for comparing an input voltage with one or more reference voltages for generating a digital value based on the input voltage. Furthermore, in memory circuits, such as a random-access memory (RAM), e.g. a static RAM (SRAM) or a dynamic RAM (DRAM), or a read-only memory (ROM), a latched comparator may be utilized as or in a sense amplifier of a read-out circuitry of the memory circuit for determining whether a logic '0' or '1' is stored in a memory cell of the memory circuit.

A latched comparator may have a differential output port comprising two output terminals. A latched comparator typically operates in two clock phases; a reset phase and a compare-and-latch phase. During the reset phase, the latched comparator is reset, e.g. by balancing the two output terminals of the latched comparators. During the compare-and-latch phase, the latched comparator is operative to compare the two input voltages and generate a differential output voltage corresponding to a logic '0' or '1' based on the two input voltages.

A latched comparator typically includes one or more cross-coupled transistor pairs, such as a cross-coupled NMOS pair and/or a cross-coupled PMOS pair, operatively connected between two output terminals. The one or more cross-coupled transistor pairs provide a positive feedback loop. The positive feedback loop forces one of the output terminals to a first voltage level, such as the supply voltage, and the other output terminal to another voltage level, such as ground, during the compare phase based on the two input voltages.

A latched comparator may comprise a switch connected between the two output terminals. During the reset phase, the switch is closed for balancing the voltages at the two output terminals, e.g. by forcing the voltages to a common level. Alternatively or additionally, the latched comparator may comprise switches connected between each of the output terminals of the latched comparator and a common reference voltage level, such as the supply voltage or ground. Said switches are closed during the reset phase and open during the compare-and-latch phase.

The operational speed of a latched comparator may be a limiting factor for the operational speed of electronic circuits comprising the latched comparator. For example, the operational speed of a latched comparator may be a limiting factor for the maximum sampling frequency of an ADC comprising the latched comparator. As another example, the operational speed of a latched comparator utilized for sense amplification in a memory circuit may be a limiting factor for the maximum read-out rate of the memory circuit. Hence, there is a need for a latched comparator circuit having an improved operational speed.

US 5,486,785 discloses a level shift circuit provided with feedforward control to keep the circuit from latching in a wrong logic state that comprises a pair of input transistors acted as a differential amplifier and a pair of output hold transistors coupled to output nodes of the circuit. The feedforward control is performed by a pair of feedforward transistors respectively coupled in parallel to the corresponding output hold transistors, and by a pair of isolation transistors that isolate the output nodes from gates of the respective feedforward transistors.

### Summary

An object of the present invention is to provide an improved latched comparator circuit.

According to a first aspect, a latched comparator circuit is provided. The latched comparator circuit comprises a first and a second output terminal for outputting a first and a second output voltage, respectively, of the latched comparator circuit. Furthermore, the latched comparator circuit comprises a cross-coupled pair of transistors operatively connected between the first and the second output terminal for providing a positive feedback in the latched comparator circuit. In addition, the latched comparator circuit comprises a reset terminal for receiving a reset signal and reset circuitry arranged to balance the first and the second output voltage during a first phase of the reset signal and allow a voltage difference to develop between the first and the second output voltage during a second phase of the reset signal. Moreover, the latched comparator circuit comprises a load unit operatively connected to the cross-coupled pair of transistors, and a bias circuit arranged to receive the reset signal and to bias the load unit such that a conductivity of the load unit is higher during the second phase of the reset signal than during the first phase of the reset signal, whereby said positive feedback is stronger during the second phase of the reset signal than during the first phase of the reset signal.

The reset circuitry may be a reset switch device operatively connected between the first and the second output terminal. The reset switch device may be arranged to be closed during the first phase of the reset signal and open during a second phase of the reset signal.

The load unit may comprise a first load circuit operatively connected between a first transistor of the cross-coupled pair of transistors and a reference node and a second load circuit operatively connected between a second transistor of the cross-coupled pair of transistors and the reference node. The bias circuit may be arranged to bias the first and the second load circuit such that a conductivity of the first load circuit and a conductivity of the second load circuit are higher during the second phase of the reset signal than during the first phase of the reset signal.

The first and second transistors of the cross-coupled pair may be MOS transistors of the same type.

The first load circuit may comprise a first load transistor of the same type as the first transistor of the cross-coupled pair. The drain terminal of the first load transistor may be operatively connected to the source terminal of the first transistor of the cross-coupled pair, the source terminal of the first load transistor may be operatively connected to the reference node, and the gate terminal of the first load transistor may be arranged to receive a bias voltage. Similarly, the second load circuit may comprise a second load transistor of the same type as the second transistor of the cross-coupled pair. The drain terminal of the second load transistor may be operatively connected to the source terminal of the second transistor of the cross-coupled pair, the source terminal of the second load transistor may be operatively connected to the reference node, and the gate terminal of the second load transistor may be arranged to receive a bias voltage.

The bias circuit may comprise a first MOS transistor of opposite type to the first and second load transistor. The first MOS transistor may be arranged to be biased with a dc voltage on its gate terminal. Furthermore, the bias circuit may comprise a bias-voltage generating transistor of the same type as the first and second load transistor. The gate terminal of the bias-voltage generating transistor may be operatively connected to the drain terminal of the first MOS transistor and the source terminal of the bias-voltage generating transistor may be operatively connected to the reference node. Moreover, the bias circuit may comprise a switch device operatively connected between the drain and gate terminals of the bias-voltage generating transistor. The switch device may be arranged to be closed during the first phase of the reset signal and open during the second phase of the reset signal. The bias circuit may be arranged to generate the bias voltage for the first and the second load transistor on the gate terminal of the bias-voltage generating transistor.

The load unit may comprise a first load element operatively connected to a first transistor of the cross-coupled pair of transistors with a first terminal of the first load element and to a reference node with a second terminal of the first load element. Similarly, the load unit may comprise a second load element operatively connected to a second transistor of the cross-coupled pair of transistors with a first terminal of the second load element and to the reference node with a second terminal of the second load element. Moreover, the load unit may comprise a third load element operatively connected between the first terminal of the first load element and the first terminal of the second load element. The bias circuit may be arranged to bias the third load element such that a conductivity of the third load element is higher during the second phase of the reset signal than during the first phase of the reset signal.

The third load element may comprise a MOS transistor arranged to receive a bias voltage from the bias circuit on its gate terminal. The bias circuit may comprise a first MOS transistor of opposite type to the MOS transistor of the third load element. Said first MOS transistor may be arranged to be biased with a dc voltage on its gate terminal. Furthermore, the bias circuit may comprise a bias-voltage generating transistor of the same type as the MOS transistor of the third load element. The gate terminal of the bias-voltage generating transistor may be operatively connected to the drain terminal of the first MOS transistor and the source terminal of the bias-voltage generating transistor may be operatively connected to a reference node. Moreover, the bias circuit may comprise a switch device operatively connected between the drain and gate terminals of the bias-voltage generating transistor. The switch device may be arranged to be closed during the first phase of the reset signal and open during the second phase of the reset signal. The bias circuit may be arranged to generate the bias voltage for the MOS transistor of the third load element on the gate terminal of the bias-voltage generating transistor.

According to a second aspect, an electronic circuit comprises a latched comparator circuit according to the first aspect. In the electronic circuit, the latched comparator circuit may be arranged to generate a differential output signal of the latched comparator circuit on the first and second output terminals of the latched comparator circuit. Alternatively, the latched comparator circuit may be arranged to generate a single-ended output signal of the latched comparator circuit on one of the first and second output terminals of the latched comparator circuit. The electronic circuit may e.g. be, but is not limited to, an analog-to-digital converter or a memory circuit.

According to a third aspect, an integrated circuit comprises a latched comparator circuit according to the first aspect.

According to a fourth aspect, an electronic apparatus comprises a latched comparator circuit according to the first aspect. The electronic apparatus may e.g. be, but is not limited to, a television set, a liquid-crystal display, a computer monitor, a digital camera, a projector, or a radio receiver.

Further embodiments of the invention are defined in the dependent claims.

It should be emphasized that the term "comprises/comprising" when used in this specification is taken to specify the presence of stated features, integers, steps, or components, but does not preclude the presence or addition of one or more other features, integers, steps, components, or groups thereof.

### Brief Description of the Drawings

Further objects, features and advantages of the invention will appear from the following detailed description of the invention, reference being made to the accompanying drawings, in which:
Figs. 1 - 4 are circuit diagrams of latched comparator circuits according to embodiments;
Figs. 5a and b are block diagrams of electronic circuits according to embodiments;
Fig. 6 illustrates schematically an integrated circuit according to an embodiment; and
Fig. 7 illustrates schematically an electronic apparatus according to an embodiment.

### Detailed Description

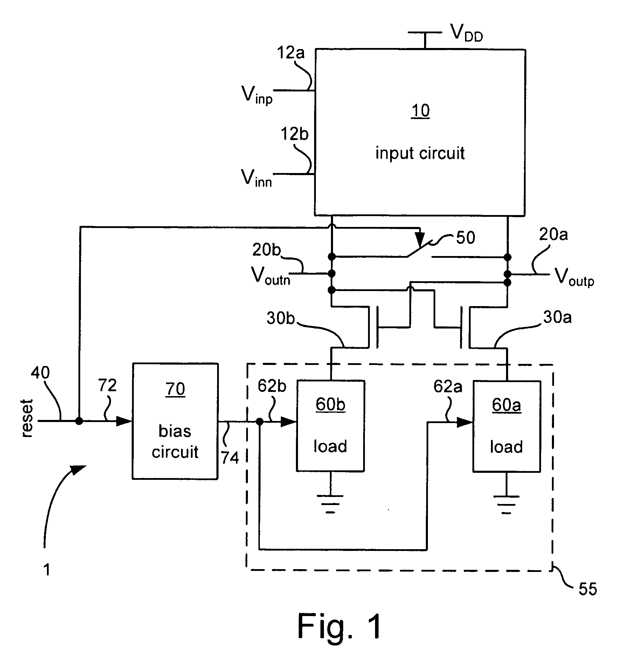

Fig. 1 is a circuit diagram of a latched comparator circuit 1 according to an embodiment. According to the embodiment, the latched comparator circuit 1 comprises an input circuit 10. The input circuit 10 has a positive and a negative input terminal 12a and 12b for receiving a positive input voltage Vᵢₙₚ and a negative input voltage Vᵢₙₙ, respectively. Hence, according to the embodiment, the latched comparator circuit is arranged to receive a differential input voltage Vᵢₙₚ - Vᵢₙₙ. According to other embodiments, a single-ended input voltage may be used, e.g. by means of connecting one of the input terminals 12a and 12b to a constant voltage and use the other as a single-ended input terminal. The input circuit 10 may be connected to a reference node, such as a supply-voltage node V_{DD}, as indicated in Fig. 1.

Furthermore, according to the embodiment illustrated in Fig. 1, the latched comparator circuit 1 comprises a positive and a negative output terminal 20a and 20b for outputting a positive output voltage Vₒᵤₜₚ and a negative output voltage V_{outn,} respectively, of the latched comparator circuit 1. Hence, according to the embodiment, the latched comparator circuit 1 is arranged to output a differential output voltage Vₒᵤₜₚ - Vₒᵤₜₙ. According to some embodiments, one of the output terminals 20a and 20b may be utilized as a single-ended output terminal, e.g. in an electronic circuit comprising the latched comparator circuit 1.

Furthermore, according to the embodiment illustrated in Fig. 1, the latched comparator circuit 1 comprises a cross-coupled pair of transistors 30a and 30b operatively connected between the first and the second output terminal 20a and 20b. In the embodiment illustrated in Fig. 1, the transistors 30a and 30b are both NMOS transistors. According to other embodiments, the transistors 30a and 30b may both be PMOS transistors. According to yet other embodiments, other types of transistors, such as but not limited to bipolar junction transistors (BJTs) may be used. Moreover, according to the embodiment, the latched comparator circuit 1 comprises a reset terminal 40 for receiving a reset signal. The latched comparator circuit 1 is adapted to be reset in a first phase of the reset signal. Furthermore, the latched comparator circuit 1 is adapted to perform a compare-and-latch operation during a second phase of the reset signal.

According to embodiments, the latched comparator circuit 1 comprises reset circuitry arranged to balance the positive and the negative output voltage Vₒᵤₜₚ and Vₒᵤₜₙ during the first phase of the reset signal, e.g. by causing the positive output voltage Vₒᵤₜₚ and the negative output voltage Vₒᵤₜₙ to be equal or approximately equal. Furthermore, the reset circuitry is arranged to allow a voltage difference to develop between the positive and the negative output voltage Vₒᵤₜₚ and Vₒᵤₜₙ during the second phase of the reset signal. According to the embodiment illustrated in Fig. 1, the reset circuitry is a reset switch device (50) operatively connected between the positive and the negative output terminal 20a and 20b. The reset switch device 50 may be arranged to be closed during the first phase of the reset signal for balancing the positive and the negative output voltage Vₒᵤₜₚ and V_{outn.} Furthermore, the reset switch device 50 may be arranged to be open during the second phase of the reset signal, thereby allowing a voltage difference to develop between the positive and the negative output voltage Vₒᵤₜₚ and Vₒᵤₜₙ.

A cross-coupled pair of transistors, such as the cross-coupled pair of transistors 30a and 30b in Fig. 1, provides a positive feedback loop in a latched comparator circuit. In accordance with embodiments of the present invention, problems for obtaining an increased operational speed have been identified in conventional latched comparator circuits. A strong positive feedback is desirable in the feedback loop in order for a latched comparator circuit to settle quickly during the compare-and-latch operation. However, with a strong positive feedback, a conventional latched comparator circuit becomes difficult to reset. Reset circuitry, such as a reset switch device like the reset switch device 50 in Fig. 1, needs to overcome the positive feedback in order to balance the output voltages. If the positive feedback is relatively strong, a relatively low on resistance is required in such a reset switch device. The reset switch device may e.g. be implemented with a MOS (Metal Oxide Semiconductor) transistor. To obtain a relatively low on resistance, the width-over-length (W/L) ratio of the MOS transistor can be made relatively large. For example, a relatively wide transistor of minimum or close to minimum length (for a given manufacturing process) can be used. However, a relatively wide transistor provides relatively large parasitic capacitances, which in turn slow down the operation of the latched comparator circuit during the compare-and-latch operation. In addition, the wider the transistor in the reset switch device is made, the larger the problem with channel charge injection from the reset switch device becomes. That is, the wider the transistor is, the larger is the channel charge. Channel-charge injection from the reset switch device may lead to erroneous comparison results in the latched comparator circuit, especially when the difference between the input voltages is relatively small.

To alleviate the above problems, a load unit 55 is comprised in the latched comparator circuit 1 according to embodiments. As illustrated in Fig. 1, the load unit 55 may be operatively connected to the cross-coupled pair of transistors. Furthermore, according to embodiments, the latched comparator circuit 1 comprises a bias circuit 70. According to embodiments, the bias circuit 70 is arranged to receive the reset signal and to bias the load unit 55 such that a conductivity of the load unit 55 is higher during the second phase of the reset signal than during the first phase of the reset signal. Thereby, as will be illustrated with reference to specific embodiments, said positive feedback can be made stronger during the second phase of the reset signal than during the first phase of the reset signal. As a consequence, a combination of a relatively fast reset and a relatively fast settling during the compare-and-latch operation is facilitated.

According to the embodiment illustrated in Fig. 1, load circuits 60a and 60b are comprised in the load unit 55. In this embodiment, the load circuit 60a is operatively connected between the transistor 30a of the cross-coupled pair of transistors and a reference node. In the embodiment, the reference node is a ground node. However, in other embodiments, the reference node may be a node having another voltage, such as but not limited to a V_{DD} node. Similarly, the load circuit 60b is operatively connected between the transistor 30b of the cross-coupled pair of transistors and the reference node. Furthermore, according to the embodiment illustrated in Fig. 1, the bias circuit 70 is arranged to receive the reset signal on an input terminal 72 and to bias the load circuits 60a and 60b. A bias control signal is supplied to bias terminals 62a and 62b of the load circuits 60a and 60b, respectively, via a bias output terminal 74 of the bias circuit 70. In Fig. 1, the load circuits 60a and 60b are biased with the same bias control signal. According to other embodiments, the bias circuit 70 may have separate bias output terminals for the load circuits 60a and 60b. By biasing the load circuits 60a and 60b differently in the first phase of the reset signal than in the second phase of the reset signal, the problems with the contradictory requirements of fast reset and fast settling during compare-and-latch operations, associated with a conventional latched comparator circuit, can be alleviated.

During a compare-and latch operation, the load circuits 60a and 60b can be biased such that a conductivity of the load circuit 60a and a conductivity of the load circuit 60b are relatively high. Thereby, a relatively strong positive feedback is obtained. As a consequence, a relatively fast settling of the latched comparator circuit 1 during compare-and-latch operations is facilitated.

During reset of the latched comparator circuit 1, the load circuits 60a and 60b can be biased such that said conductivities are relatively low. Thereby, a relatively weak positive feedback is obtained. As a consequence, the latched comparator circuit 1 can be reset relatively quickly. Furthermore, since the positive feedback during reset is relatively weak, the width of a transistor used for implementing the reset switch device 50 can be made relatively small, which in turn reduces the problems with parasitic capacitance and channel-charge injection from the reset switch device.

Therefore, in accordance with embodiments, the bias circuit 70 is arranged to bias the load circuits 60a and 60b such that the conductivity of the load circuit 60a and the conductivity of the load circuit 60b are higher during the second phase of the reset signal than during the first phase of the reset signal.

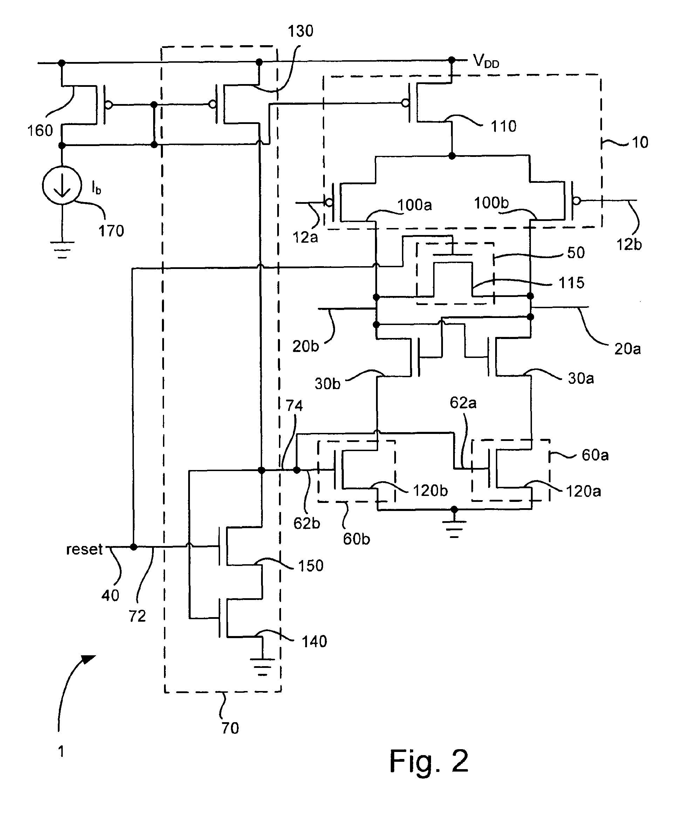

Fig. 2 is a more detailed circuit diagram of the latched comparator circuit 1 illustrated in Fig. 1 according to an embodiment. According to the embodiment, the cross-coupled pair of transistor comprises NMOS transistors 30a and 30b. Furthermore, the input circuit 10 comprises a differential transistor pair for receiving the differential input voltage of the latched comparator circuit 1. In the embodiment illustrated in Fig. 2, the transistors 100a and 100b of the differential transistor pair are PMOS transistors. Furthermore, according to the embodiment illustrated in Fig. 2, the transistors 100a and 100b are biased with a current generated by the PMOS transistor 110.

Moreover, in the embodiment illustrated in Fig. 2, the reset switch device comprises an NMOS transistor 115 connected between the output terminals 20a and 20b. Various other implementations of the reset switch device 50 are also possible. For example, according to some embodiments, the reset switch device 50 may comprise a PMOS transistor. According to some embodiments, the reset switch device 50 may comprise a transmission gate. The transmission gate may e.g. be implemented with a PMOS transistor connected in parallel with an NMOS transistor.

According to the embodiment illustrated in Fig. 2, the load circuit 60a comprises a transistor 120a and the load circuit 60b comprises a transistor 120b. The transistors 120a and 120b are in the following referred to as load transistors. In the embodiment illustrated in Fig. 2, the load transistors 120a and 120b are of the same type as the transistors 30a and 30b, i.e. NMOS transistors.

The drain terminal of the load transistor 120a is operatively connected to the source terminal of the transistor 30a. Similarly, the drain terminal of the load transistor 120b is operatively connected to the source terminal of the transistor 30b. The source terminals of the load transistors 120a and 120b are operatively connected to ground. The gate terminals of the load transistors 120a and 120b are arranged to receive bias voltages. In Fig. 2, the load transistors 120a and 120b are arranged to receive the same bias voltage. According to other embodiments, the load transistors 120a and 120b may be arranged to be biased separately.

In the embodiment illustrated in Fig. 2, the bias circuit 70 comprises a PMOS transistor 130. The transistor 130 is arranged to be biased with a dc voltage on its gate terminal. The bias circuit 70 further comprises a transistor 140 for generating a bias voltage. In the embodiment, the transistor 140 is of the same type as the load transistors 120a and 120b, i.e. NMOS transistors. The gate terminal of the transistor 140 is operatively connected to the drain terminal of the transistor 130. The source terminal of the transistor 140 is operatively connected to ground.

Furthermore, according to the embodiment illustrated in Fig. 2, the bias circuit 70 comprises a switch device 150 operatively connected between the drain and gate terminals of the transistor 140. As illustrated in Fig. 2, the switch device 150 may be implemented with a transistor, such as but not limited to an NMOS transistor. The switch device 150 is arranged to be closed during the first phase of the reset signal. Furthermore, the switch device 150 is arranged to be open during the second phase of the reset signal.

For the embodiment illustrated in Fig. 2, the bias circuit 70 is arranged to generate the bias voltage for the load transistor 120a and 120b on the gate terminal of the transistor 140.

A means for biasing the transistor 130 is illustrated in Fig. 2. The transistor 130 is connected in a current-mirror configuration with a diode-connected transistor 160, which in turn is biased by a current I_{b} from a current source 170. As an example, which is also illustrated in Fig. 2, the transistor 110 may be biased with the same gate voltage as the transistor 130. According to some embodiments, the transistors 130 and 110 may be biased separately.

When the reset signal is high, the switch device 150 and the reset switch device 50 are both closed. A current generated by the transistor 130 flows through the switch device 150 and the transistor 140. Due to the connection of the gate terminal of the transistor 140, this current is mirrored to the load transistors 120a and 120b. By properly selecting transistor sizes and bias currents, the gate-to-source voltages (V_{GS}) of the load transistors 120a and 120b can be set such that the channel charges of the load transistors 120a and 120b are relatively small. Thereby, the conductivities of the load circuits 60a and 60b may be set relatively small, which is advantageous for facilitating a relatively fast reset of the latched comparator circuit 1.

When the reset signal goes low, the reset switch device 50 is opened. Thereby, a voltage difference is allowed to develop between the output terminals 20a and 20b based on a voltage difference between the input terminals 12a and 12b. Furthermore, the switch device 150 is opened. Thereby, the current from the transistor 130 is prevented from flowing through the transistor 140. Instead, capacitance associated with the gate node of the transistor 140 is charged and the voltage on that node (i.e. the bias voltage for the load transistors 120a and 120b) gradually increases towards the supply voltage V_{DD}. Hence, the V_{GS} of the load transistors 120a and 120b gradually increases, which causes a gradual increase of the channel charges of these transistors. Thereby, the conductivities of the load circuits 120a and 120b are increased. This, in turn, causes an increased strength of the positive feedback loop in the latch circuit 1, whereby relatively fast settling of the latched comparator circuit 1 during the compare-and-latch operation is facilitated.

A circuit designer could e.g. determine how fast the gradual increase of the V_{GS} of the transistor 140 should be based on a trade-off between speed and accuracy. For example, if the speed of the gradual increase is increased, the strength of the positive feedback increases faster, whereby a faster settling is obtained. On the other hand, a smaller voltage difference is allowed to develop between the output terminals 20a and 20b before the strong positive feedback is attained, whereby the accuracy is reduced. Similarly, if the speed of the gradual increase is decreased, a larger voltage difference is allowed to develop between the output terminals 20a and 20b before the strong positive feedback is attained, whereby the accuracy is increased. However, at the same time, the strength of the positive feedback increases slower, whereby a slower settling is obtained. An appropriate speed for the gradual increase, and associated appropriate transistor dimensions, bias currents etc., may e.g. be determined by means of circuit simulation.

When the reset signal once again goes high, current is again allowed to pass through the transistor 140, whereby the capacitance associated with the gate node of the transistor 140 is discharged. Thereby the conductivities of the load circuits 120a and 120b are decreased, whereby a relatively fast reset of the latched comparator circuit is facilitated.

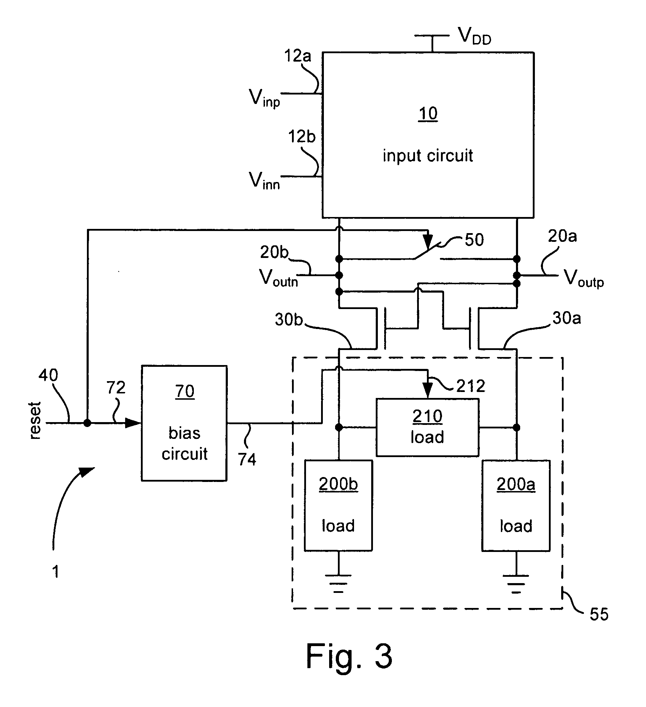

Fig. 3 is a circuit diagram of the latched comparator circuit 1 according to another embodiment. Elements that are the same or similar as elements illustrated in Fig. 1 are denoted with the same reference signs in Fig. 3 as in Fig. 1. A difference between the embodiment illustrated in Fig. 3 and the embodiment illustrated in Fig. 1 is related to elements comprised in the load unit 55. In Fig. 3, the load unit 55 comprises a load circuit, or load element, 200a operatively connected to the transistor 30a with a first terminal of the load element 200a and to a reference node with a second terminal of the first load element (200a). In Fig. 3, the reference node is a ground node. However, in other embodiments, a reference node other than ground may be used. Furthermore, in Fig. 3, the load unit 55 comprises a load circuit, or load element, 200b operatively connected to the transistor 30b with a first terminal of the load element 200b and to the reference node with a second terminal of the load element 200b. Moreover, in Fig. 3, the load unit 55 comprises a load circuit, or load element, 210 operatively connected between the first terminal of the load element 200a and the first terminal of the load element 200b. For the embodiment illustrated in Fig. 3, the bias circuit 70 is arranged to bias the load element 210 such that a conductivity of the load element 210 is higher during the second phase of the reset signal than during the first phase of the reset signal. Thereby, a relatively strong positive feedback may be obtained during a compare-and-latch operation, while a relatively weak positive feedback may be obtained during a reset operation. As a consequence, a relatively fast settling of the latched comparator circuit 1 during compare-and-latch operations is facilitated, while the latched comparator circuit 1 can be reset relatively quickly. Furthermore, since the positive feedback during reset is relatively weak, the width of a transistor used for implementing the reset switch device 50 can be made relatively small, which in turn reduces the problems with parasitic capacitance and channel-charge injection from the reset switch device.

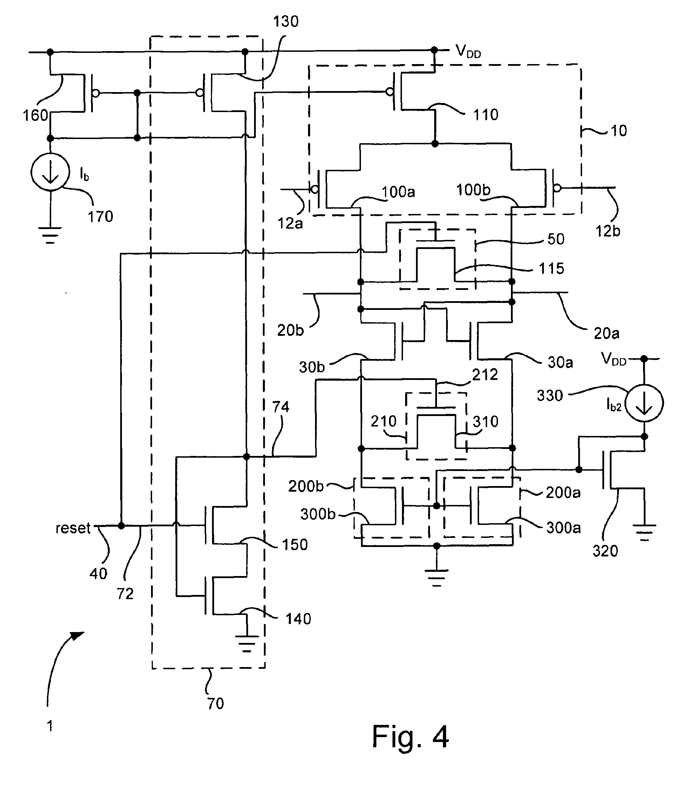

Fig. 4 is a more detailed circuit diagram of the latched comparator circuit 1 illustrated in Fig. 3 according to an embodiment. Elements that are the same or similar to elements in Fig. 2 are denoted with the same reference signs in Fig. 4 as in Fig. 2. According to the embodiment illustrated in Fig. 4, the load element 210 comprises a MOS transistor 310 arranged to receive a bias voltage from the bias circuit 70 on its gate terminal. The channel charge, and hence the conductivity, of the MOS transistor may be controlled by means of the bias voltage on the gate terminal of the MOS transistor 310. According to embodiments, the MOS transistor 310 is of the same type as the transistor 140. For example, in Fig. 4, both the transistor 140 and the transistor 310 are of NMOS type.

In Fig. 4, the bias circuit 70 is implemented in the same way as in Fig. 2. When the reset signal is high, the switch device 150 and the reset switch device 50 are both closed. A current generated by the transistor 130 flows through the switch device 150 and the transistor 140 and determines the bias voltage on the bias output terminal 74. By properly selecting transistor sizes and bias currents, the electrical potential on the gate terminal of the transistor 310 can be set such that the channel charge of the transistor 310 is relatively small during the first phase of the reset signal. Thereby, the conductivity of the load element 210 may be set relatively small, which is advantageous for facilitating a relatively fast reset of the latched comparator circuit 1.

When the reset signal goes low, the reset switch device 50 is opened. Thereby, a voltage difference is allowed to develop between the output terminals 20a and 20b based on a voltage difference between the input terminals 12a and 12b. Furthermore, the switch device 150 is opened. Thereby, the current from the transistor 130 is prevented from flowing through the transistor 140. Instead, capacitance associated with the gate node of the transistor 140 is charged and the voltage on that node (i.e. the bias voltage for the transistor 310) gradually increases towards the supply voltage V_{DD}. Hence, gate potential of the transistor 310 gradually increases, which causes a gradual increase of the channel charge of the transistor 310. Thereby, the conductivity of the load element 210 is increased. This, in turn, causes an increased strength of the positive feedback loop in the latch circuit 1, whereby relatively fast settling of the latched comparator circuit 1 during the compare-and-latch operation is facilitated.

Also for the embodiment illustrated in Fig. 4, a circuit designer may e.g. determine how fast the gradual increase of the V_{GS} of the transistor 140 should be based on the same or similar design consideration as was described with reference to Fig. 2.

In Fig. 4, the load element 200a comprises a transistor 300a connected with its source terminal to ground and with its drain terminal to the source terminal of the transistor 30a. Similarly, in Fig. 4, the load element 200b comprises a transistor 300b connected with its source terminal to ground and with its drain terminal to the source terminal of the transistor 30b. As illustrated in the figure, the transistors 300a and 300b may be NMOS transistors.

Furthermore, in the embodiment illustrated in Fig. 4, the transistors 300a and 300b are biased with a common gate-to-source voltage generated by a transistor 320 of the same type as the transistors 300a and 300b and configured in a current-mirror configuration with the transistors 300a and 300b. As illustrated in Fig. 4, the transistor 320 may be biased with a DC current I_{b2} generated by a current source unit 330.

According to some embodiments, the embodiments of load circuit 55 illustrated in Figs. 1 and 3 may be combined. For example, starting from the embodiment illustrated in Fig. 1, the load element 210 of the embodiment illustrated in Fig. 3 may be further included in the load unit 55 and operatively connected between source terminals of the transistors 30a and 30b. The bias circuit 70 may then be arranged to control the conductivities of all of the load circuits 60a and 60b and the load element 210. Similarly, with reference to Figs. 2 and 4, the NMOS transistor 310 in the embodiment illustrated in Fig. 4 may be operatively connected between the drain terminals of the load transistors 120a and 120b of the embodiment illustrated in Fig 2. The gate terminals of the transistors 120a-b and 310 may then e.g. all be connected to the bias output terminal 74 of the bias circuit 70.

Values of transistor sizes, bias currents, etc. may be selected for each implementation, e.g. based on requirements for a given application in which the latch circuit 1 is to be used (e.g. requirements on speed, power consumption, etc.), process parameters for a given manufacturing process, etc. The selection may e.g. be based on simulations and/or measurements.

The circuit diagrams shown in Figs. 1 - 4 are only illustrations of exemple embodiments. Various variations are possible within the scope of the invention. For example, complementary circuits, where all NMOS transistors are replaced with PMOS transistors, all PMOS transistors are replaced with NMOS transistors, and all connections to V_{DD} and ground are interchanged, may be employed. Furthermore, other types of transistors than MOS transistors, such as BJTs, may be used. For example one or more of the NMOS transistors may be replaced with NPN transistors. Similarly, one or more of the PMOS transistors may be replaced with PNP transistors. Moreover, the transistor 140 in Fig. 2 and Fig. 4 could e.g. be replaced with a resistor connected between ground and the source terminal of the transistor 150. Similarly, the transistors 300a and 300b in Fig. 4 could e.g. be replaced with resistors connected between ground and the source terminals of the transistors 30a and 30b, respectively.

Furthermore, intervening elements (e.g. cascode transistors, resistors, etc.) may be inserted between elements that are illustrated as directly connected in Figs. 1 - 4.

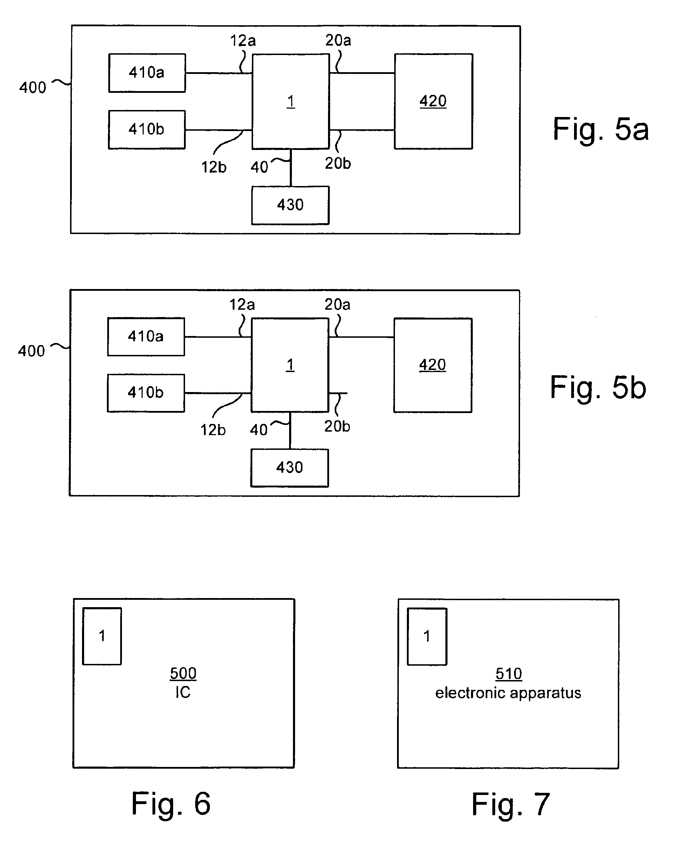

An electronic circuit 400 may comprise the latched comparator circuit 1 according to embodiments. This is schematically illustrated in Figs. 5a and b, showing an electronic apparatus 400 comprising a latched comparator circuit 1, units 410a and 410b for supplying input signals to the latched comparator circuit 1, a processing unit 420 for processing data output from the latched comparator circuit, and a control unit 430 for controlling the reset of the latched comparator circuit 1. In some embodiments, the latched comparator circuit 1 may be arranged in the electronic circuit 400 to generate a differential output signal of the latched comparator circuit 1 on the output terminals 20a and 20b of the latched comparator circuit 1. This is illustrated in Fig. 5a, where the processing unit 420 is connected to both of the output terminals 20a and 20b of the latched comparator circuit 1. According to some embodiments, the latched comparator circuit 1 is arranged in the electronic circuit 400 to generate a single-ended output signal of the latched comparator circuit 1 on one of the output terminals 20a and 20b of the latched comparator circuit 1. This is illustrated in Fig. 5b, where the processing unit 420 is connected only to the output terminal 20a of the latched comparator circuit 1, whereas the output terminal 20b of the latched comparator circuit is left unconnected.

A nonlimiting example of an electronic circuit 400 that may comprise one or more latched comparator circuits 1 is an analog-to-digital converter (ADC). The latched comparator circuit 1 may e.g. be connected in a comparator arrangement of the ADC. The comparator arrangement may be adapted to compare an analog input signal of the ADC, or a signal derived therefrom, with one ore more reference levels of the ADC for generating a digital output signal of the ADC based on the analog input signal. The comparator arrangement may comprise one or more comparators connected in cascade. Due to the relatively high operational speed provided by the latched comparator circuit 1, it is suitable for use in ADCs for high-speed applications, such as but not limited to video applications. In some video applications, ADC sampling rates up to 270 MHz or even higher may be required.

Another nonlimiting example of an electronic circuit 400 that may comprise the latched comparator circuit 1 is a memory circuit. The memory circuit may e.g. be a random access memory (RAM) such as a static RAM (SRAM) or a dynamic RAM (DRAM), or a read-only memory (ROM). For example, one or more latched comparator circuits 1 may be comprised in sense-amplification circuitry of the memory circuit. Due to the relatively high operational speed of the latched comparator circuit 1, a relatively high read-out rate may thereby be accomplished in the memory circuit.

According to some embodiments, an integrated circuit (IC) comprises the latched comparator circuit 1. This is schematically illustrated in Fig. 6, showing an IC 500 comprising a latched comparator circuit 1. For example, the IC 500 may comprise an ADC and/or a memory circuit that in turn comprise one or more latched comparator circuits 1.

According to some embodiments, an electronic apparatus comprises one or more latched comparator circuits 1. This is schematically illustrated in Fig. 7, showing an electronic apparatus 510 comprising a latched comparator circuit 1.For example, the electronic apparatus 510 may comprise an ADC, a memory circuit, and/or an integrated circuit that in turn comprise one or more latched comparator circuits 1.

The electronic apparatus 510 may e.g. be, but is not limited to, a television set, a liquid-crystal display, a computer monitor, a digital camera, a projector, or a radio receiver.

According to some embodiments, a method of operating the latched comparator circuit 1 is provided. During the first phase of the reset signal, embodiments of the method comprises biasing the load unit 50 in a first state and balancing the positive and the negative output voltages Vₒᵤₜₚ and V_{outn.} During the second phase of the reset signal, embodiments of the method comprises biasing the load unit 50 in a second state, in which a conductivity of the load unit 50 is higher than in the first state, and allowing a voltage difference to develop between the positive and the negative output voltage Vₒᵤₜₚ and Vₒᵤₜₙ. Thereby, as described above, the positive feedback can be made stronger during the second phase of the reset signal than during the first phase of the reset signal.

The present invention has been described above with reference to specific embodiments. However, other embodiments than the above described are possible within the scope of the invention. Different method steps than those described above, may be provided within the scope of the invention. The different features and steps of the invention may be combined in other combinations than those described. The scope of the invention is only limited by the appended patent claims.

## Claims

1. A latched comparator circuit (1) comprising
- a first and a second output terminal (20a, 20b) for outputting a first and a second output voltage, respectively, of the latched comparator circuit (1);
- a cross-coupled pair of transistors (30a, 30b) operatively connected between the first and the second output terminal (20a, 20b) for providing a positive feedback in the latched comparator circuit (1);
- a reset terminal (40) for receiving a reset signal; and
- reset circuitry arranged to balance the first and the second output voltage during a first phase of the reset signal and allow a voltage difference to develop between the first and the second output voltage during a second phase of the reset signal;
**characterized by**
- a load unit (55) operatively connected to the cross-coupled pair of transistors; and
- a bias circuit (70) arranged to receive the reset signal and to bias the load unit (55) such that a conductivity of the load unit (55) is higher during the second phase of the reset signal than during the first phase of the reset signal, whereby said positive feedback is stronger during the second phase of the reset signal than during the first phase of the reset signal.

2. The latched comparator circuit (1) according to claim 1, wherein the reset circuitry is a reset switch device (50) operatively connected between the first and the second output terminal (20a, 20b), wherein the reset switch device (50) is arranged to be closed during the first phase of the reset signal and open during a second phase of the reset signal.

3. The latched comparator circuit (1) according to claim 1 or 2, wherein the load unit (55) comprises:
- a first load circuit (60a) operatively connected between a first transistor (30a) of the cross-coupled pair of transistors and a reference node; and
- a second load circuit (60b) operatively connected between a second transistor (30b) of the cross-coupled pair of transistors and the reference node; and
wherein the bias circuit (70) is arranged to bias the first and the second load circuit (60a, 60b) such that a conductivity of the first load circuit (60a) and a conductivity of the second load circuit (60b) are higher during the second phase of the reset signal than during the first phase of the reset signal.

4. The latched comparator circuit (1) according to claim 3, wherein the first and second transistors (30a, 30b) of the cross-coupled pair are MOS transistors of the same type.

5. The latched comparator circuit (1) according to claim 4, wherein
- the first load circuit (60a) comprises a first load transistor (120a) of the same type as the first transistor (30a) of the cross-coupled pair, wherein the drain terminal of the first load transistor (120a) is operatively connected to the source terminal of the first transistor (30a) of the cross-coupled pair, the source terminal of the first load transistor (120a) is operatively connected to the reference node, and the gate terminal of the first load transistor (120a) is arranged to receive a bias voltage; and
- the second load circuit (60b) comprises a second load transistor (120b) of the same type as the second transistor (30b) of the cross-coupled pair, wherein the drain terminal of the second load transistor (120b) is operatively connected to the source terminal of the second transistor (30b) of the cross-coupled pair, the source terminal of the second load transistor (120b) is operatively connected to the reference node, and the gate terminal of the second load transistor (120b) is arranged to receive a bias voltage.

6. The latched comparator circuit (1) according to claim 5, wherein the bias circuit (70) comprises
- a first MOS transistor (130) of opposite type to the first and second load transistor (120a, 120b), wherein the first MOS transistor (130) is arranged to be biased with a dc voltage on its gate terminal;
- bias-voltage generating transistor (140) of the same type as the first and second load transistor (120a, 120b), wherein the gate terminal of the bias-voltage generating transistor (140) is operatively connected to the drain terminal of the first MOS transistor (130) and the source terminal of the bias-voltage generating transistor (140) is operatively connected to the reference node; and
- a switch device (150) operatively connected between the drain and gate terminals of the bias-voltage generating transistor, wherein the switch device (150) is arranged to be closed during the first phase of the reset signal and open during the second phase of the reset signal;
wherein the bias circuit (70) is arranged to generate the bias voltage for the first and the second load transistor (120a, 120b) on the gate terminal of the bias-voltage generating transistor (140).

7. The latched comparator circuit according to claim 1 or 2, wherein the load unit (55) comprises:
- a first load element (200a) operatively connected to a first transistor (30a) of the cross-coupled pair of transistors with a first terminal of the first load element (200a) and to a reference node with a second terminal of the first load element (200a);
- a second load element (200b) operatively connected to a second transistor (30b) of the cross-coupled pair of transistors with a first terminal of the second load element (200b) and to the reference node with a second terminal of the second load element (200b); and
- a third load element (210) operatively connected between the first terminal of the first load element (200a) and the first terminal of the second load element (200b); and
wherein the bias circuit (70) is arranged to bias the third load element (210) such that a conductivity of the third load element (210) is higher during the second phase of the reset signal than during the first phase of the reset signal.

8. The latched comparator circuit (1) according to claim 7, wherein the third load element (210) comprises a MOS transistor (310) arranged to receive a bias voltage from the bias circuit (70) on its gate terminal.

9. The latched comparator circuit (1) according to claim 8, wherein the bias circuit (70) comprises
- a first MOS transistor (130) of opposite type to the MOS transistor (310) of the third load element (210), wherein the first MOS transistor (130) is arranged to be biased with a dc voltage on its gate terminal;
- bias-voltage generating transistor (140) of the same type as the MOS transistor (310) of the third load element, wherein the gate terminal of the bias-voltage generating transistor (140) is operatively connected to the drain terminal of the first MOS transistor (130) and the source terminal of the bias-voltage generating transistor (140) is operatively connected to a reference node; and
- a switch device (150) operatively connected between the drain and gate terminals of the bias-voltage generating transistor, wherein the switch device (150) is arranged to be closed during the first phase of the reset signal and open during the second phase of the reset signal;
wherein the bias circuit (70) is arranged to generate the bias voltage for the MOS transistor (310) of the third load element (210) on the gate terminal of the bias-voltage generating transistor (140).

10. An electronic circuit (400) comprising a latched comparator circuit (1) according to any preceding claim.

11. The electronic circuit (400) according to claim 10, wherein the latched comparator circuit (1) is arranged to generate a differential output signal of the latched comparator circuit (1) on the first and second output terminals (20a, 20b) of the latched comparator circuit (1).

12. The electronic circuit (400) according to claim 10, wherein the latched comparator circuit (1) is arranged to generate a single-ended output signal of the latched comparator circuit (1) on one of the first and second output terminals (20a, 20b) of the latched comparator circuit (1).

13. The electronic circuit (400) according to any of the claims 10 - 12, wherein the electronic circuit is an analog-to-digital converter or a memory circuit.

14. An integrated circuit (500) comprising a latched comparator circuit (1) according to any of the claims 1 - 9.

15. An electronic apparatus (510) comprising a latched comparator circuit (1) according to any of the claims 1 - 9.

16. The electronic apparatus (510) according to claim 15, wherein the electronic apparatus (510) is a television set, a liquid-crystal display, a computer monitor, a digital camera, a projector, or a radio receiver.

## Patentansprüche

1. Eine gelatchte Komparatorschaltung (1) umfassend
- einen ersten und einen zweiten Ausgangsanschluss (20a, 20b) für die Ausgabe von jeweils einer ersten und einer zweiten Ausgangsspannung der gelatchten Komparatorschaltung (1);
- ein über Kreuz gekoppeltes Paar von Transistoren (30a, 30b), die zwischen den ersten und den zweiten Ausgangsanschluss (20a, 20b) operativ geschaltet sind, um eine positive Rückkopplung der gelatchten Komparatorschaltung (1) zu verursachen;
- einen Reset-Anschluss (40), um ein Reset-Signal zu empfangen; und
- eine Reset-Schaltkreisanordnung, die ausgebildet ist, um die erste und zweite Ausgangsspannung während einer ersten Phase des Reset-Signals auszugleichen und um die Entwicklung einer Spannungsdifferenz zwischen der ersten und der zweiten Ausgangsspannung während einer zweiten Phase des Rest-Signals zu ermöglichen;
**gekennzeichnet durch**
- eine Ladeeinheit (55) , die mit dem über Kreuz gekoppelten Paar von Transistoren operativ verbunden ist; und
- eine BIAS-Schaltung (70), die ausgebildet ist, um das Reset-Signal zu empfangen und die Ladeeinheit (55) derart unter Vorspannung zu setzen, dass eine Leitfähigkeit der Ladeeinheit (55) während der zweiten Phase des Reset-Signals höher ist als während der ersten Phase des Reset-Signals, wobei die positive Rückkopplung während der zweiten Phase des Reset-Signals stärker ist als während der ersten Phase des Reset-Signals.

2. Gelatchte Komparatorschaltung (1) nach Anspruch 1, **dadurch gekennzeichnet, dass** die Reset-Schaltkreisanordnung eine Reset-Schaltvorrichtung (50) ist, die zwischen den ersten und den zweiten Ausgangsanschluss (20a, 20b) operativ geschaltet ist, wobei die Reset-Schaltvorrichtung (50) ausgestaltet ist, um während der ersten Phase des Reset-Signals geschlossen und während der zweiten Phase des Reset-Signals geöffnet zu sein.

3. Gelatchte Komparatorschaltung (1) nach Anspruch 1 oder 2, **dadurch gekennzeichnet, dass** die Ladeeinheit (55) umfasst:
- eine erste Ladeschaltung (60a), die zwischen einen ersten Transistor (30a) des über Kreuz gekoppelten Paares von Transistoren und einen Referenzknoten operativ geschaltet ist, und
- eine zweite Ladeschaltung (60b), die zwischen einen zweiten Transistor (30b) des über Kreuz gekoppelten Paares von Transistoren und den Referenzknoten operativ geschaltet ist; und
wobei die BIAS-Schaltung (70) ausgebildet ist, um die erste und die zweite Ladeschaltung (60a, 60b) unter Vorspannung zu setzten, so dass eine Leitfähigkeit der ersten Ladeschaltung (60a) und eine Leitfähigkeit der zweiten Ladeschaltung (60b) während der zweiten Phase des Reset-Signals höher sind als während der ersten Phase des Reset-Signals.

4. Gelatchte Komparatorschaltung (1) nach Anspruch 3, **dadurch gekennzeichnet, dass** der erste und der zweite Transistor (30a, 30b) des über Kreuz gekoppelten Paares MOS-Transistoren des gleichen Typs sind.

5. Gelatchte Komparatorschaltung (1) nach Anspruch 4, **dadurch gekennzeichnet, dass**
- die erste Ladeschaltung (60a) einen Lade-Transistor (120a) des gleichen Typs wie der erste Transistor (30a) des über Kreuz gekoppelten Paares umfasst, wobei der Drain-Anschluss des ersten Lade-Transistors (120a) mit dem Quell-Anschluss des ersten Transistors (30a) des über Kreuz gekoppelten Paares operativ verbunden ist, der Quell-Anschluss des ersten Lade-Transistors (120a) mit dem Referenzknoten operativ verbunden ist, und der Gate-Anschluss des ersten Lade-Transistors (120a) ausgebildet ist, um eine BIAS-Spannung zu erhalten; und
- die zweite Ladeschaltung (60b) einen zweiten Lade-Transistor (120b) des gleichen Typs wie der zweite Transistor (30b) des über Kreuz gekoppelten Paares umfasst, wobei der Drain-Anschluss des zweiten Lade-Transistors (120b) mit dem Quell-Anschluss des zweiten Transistors (30b) des über Kreuz gekoppelten Paares operativ verbunden ist, der Quell-Anschluss des zweiten Lade-Transistors (120b) mit dem Referenzknoten operativ verbunden ist, und der Gate-Anschluss des zweiten Lade-Transistors (120b) ausgebildet ist, um BIAS-Spannung zu erhalten.

6. Gelatchte Komparatorschaltung (1) nach Anspruch 5, **dadurch gekennzeichnet, dass** die BIAS-Schaltung'(70) umfasst
- einen ersten MOS-Transistor (130) des entgegengesetzten Typs wie der erste und der zweite Lade-Transistor (120a, 120b), wobei der erste MOS-Transistor (130) ausgebildet ist, um an seinem Gate-Anschluss mit einer Gleichspannung unter Vorspannung gesetzt zu werden;
- einen Vorspannung erzeugenden Transistor (140) desselben Typs wie der erste und der zweite Lade-Transistor (120a, 120b) , wobei das Gate-Anschluss des Vorspannung erzeugenden Transistors (140) mit dem Drain-Anschluss des ersten MOS-Transistors (130) operativ verbunden ist und der Quell-Anschluss des Vorspannung erzeugenden Transistors (140) mit dem Referenzknoten operativ verbunden ist; und
- eine Schalteinrichtung (150) die zwischen den Drain- und den Gate-Anschluss des Vorspannung erzeugenden Transistors operativ geschaltet ist, wobei die Schalteinrichtung (150) ausgebildet ist, um während der ersten Phase des Reset-Signals geschlossen und während der zweiten Phase des Reset-Signals geöffnet zu sein;
wobei die BIAS-Schaltung (70) ausgebildet ist, um die Vorspannung für den ersten und den zweiten Ladetransistor (120a, 120b) an dem Gate-Anschluss des Vorspannung erzeugenden Transistor (140) zu erzeugen.

7. Gelatchte Komparatorschaltung nach Anspruch 1 oder 2, **dadurch gekennzeichnet, dass** die Ladeeinheit (55) umfasst:
- ein erstes Lade-Element (200a), welches mit einem ersten Transistor (30a) des über Kreuz gekoppelten Paares von Transistoren mit einem ersten Anschluss des ersten Lade-Elementes (200a) operativ verbunden ist und mit einem Referenzknoten mit einem zweiten Anschluss des ersten Lade-Elementes (200a);
- ein zweites Lade-Element (200b), welches mit einem zweiten Transistor (30b) des über Kreuz gekoppelten Paares von Transistoren mit einem ersten Anschluss des zweiten Lade-Elementes (200b) operativ verbunden ist und mit einem Referenzknoten mit einem zweiten Anschluss des zweiten Lade-Elementes (200b); und
- ein drittes Lade-Element (210), welches zwischen den ersten Anschluss des ersten Lade-Elementes (200a) und den ersten Anschluss des zweiten Lade-Elementes (200b) operativ geschaltet ist; und
wobei die BIAS-Schaltung (70) ausgebildet ist, um das dritte Lade-Element (210) derart unter Vorspannung zu setzen, dass eine Leitfähigkeit des dritten Lade-Elementes (210) während der zweiten Phase des Reset-Signals höher ist, als während der ersten Phase des Reset-Signals.

8. Gelatchte Komparaotorschaltung (1) nach Anspruch 7, **dadurch gekennzeichnet, dass** das dritte Ladeelement (210) einen MOS-Transistor (310) umfasst, der ausgebildet ist, um an seinem Gate-Anschluss eine Vorspannung von der BIAS-Schaltung (70) zu erhalten.

9. Gelatchte Komparatorschaltung (1) nach Anspruch 8, **dadurch gekennzeichnet, dass** die BIAS-Schaltung (70) umfasst
- einen ersten MOS-Transistor (130) des entgegengesetzten Typs wie der MOS-Transistor (310) des dritten Lade-Elementes (210), wobei der erste MOS-Transistor (130) ausgebildet ist, um an seinem Gate-Anschluss mit einer Gleichspannung unter Vorspannung gesetzt zu werden;
- einen Vorspannung erzeugenden Transistor (140) des gleichen Typs wie der MOS-Transistor (310) des dritten Ladeelementes, wobei der Gate-Anschluss des Vorspannung erzeugenden Transistors (140) mit dem Drain-Anschluss des ersten MOS-Transistors (130) operativ verbunden ist und der Quell-Anschluss des Vorspannung erzeugenden Transistors (140) mit dem Referenzknoten operativ verbunden ist; und
- eine Schalteinrichtung (150), die zwischen den Drain- und den Gate-Anschluss des Vorspannung erzeugenden Transistors operativ geschaltet ist, wobei die Schalteinrichtung (150) ausgebildet ist, um während der ersten Phase des Reset-Signals geschlossen und während der zweiten Phase des Reset-Signals geöffnet zu sein;
wobei die BIAS-Schaltung (70) ausgebildet ist, um die Vorspannung für den MOS-Transistor (310) des dritten Lade-Elementes (210) an dem Gate-Anschluss des Vorspannung erzeugenden Transistors (140) zu erzeugen.

10. Eine elektronische Schaltung (400) umfassend eine gelatchte Komparatorschaltung (1) nach einem der vorhergehenden Ansprüche.

11. Elektronische Schaltung (400) nach Anspruch 10, **dadurch gekennzeichnet, dass** die gelatchte Komparatorschaltung (1) ausgebildet ist, um ein differenzielles Ausgangssignal der gelatchten Komparatorschaltung (1) an dem ersten und dem zweiten Ausgangs-Anschluss (20a, 20b) der gelatchten Komparatorschaltung (1) zu erzeugen.

12. Elektronische Schaltung (400) nach Anspruch 10, **dadurch gekennzeichnet, dass** die gelatchte Komparatorschaltung (1) ausgebildet ist, um ein Eintakt-Ausgangssignal der gelatchten Komparatorschaltung (1) an einem von dem ersten und dem zweiten Ausgangs-Anschluss (20a, 20b) der gelatchten Komparatorschaltung (1) zu erzeugen.

13. Elektronische Schaltung (400) nach einem der Ansprüche 10 bis 12, **dadurch gekennzeichnet, dass** die elektronische Schaltung ein Analog-Digitalwandler oder eine Speicherschaltung ist.

14. Eine integrierte Schaltung (500), umfassend eine gelatchte Komparatorschaltung (1) nach einem der Ansprüche 1 bis 9.

15. Eine elektronische Vorrichtung (510), umfassend eine gelatchte Komparatorschaltung (1) nach einem der Ansprüche 1 bis 9.

16. Elektronische Vorrichtung (510) nach Anspruch 15, **dadurch gekennzeichnet, dass** die elektronische Vorrichtung (510) ein Fernsehgerät, ein LCD-Display, ein Computermonitor, eine Digitalkamera, ein Projektor oder ein Funkempfänger ist.

## Revendications

1. Circuit comparateur verrouillé (1) comprenant :
- des première et seconde bornes de sortie (20a, 20b) pour générer en sortie des première et seconde tensions de sortie, respectivement, du circuit comparateur verrouillé (1) ;
- une paire de transistors à couplage transversal (30a, 30b) connectés de manière fonctionnelle entre les première et seconde bornes de sortie (20a, 20b) en vue de fournir une rétroaction positive dans le circuit comparateur verrouillé (1) ;
- une borne de réinitialisation (40) pour recevoir un signal de réinitialisation ; et
- un montage de circuits de réinitialisation, agencé de manière à équilibrer les première et seconde tensions de sortie au cours d'une première phase du signal de réinitialisation, et à permettre le développement d'une différence de tension entre les première et seconde tensions de sortie au cours d'une seconde phase du signal de réinitialisation ;
**caractérisé par** :
- une unité de charge (55) connectée de manière fonctionnelle à la paire de transistors à couplage transversal ; et
- un circuit de polarisation (70) agencé de manière à recevoir le signal de réinitialisation et à polariser l'unité de charge (55), de sorte qu'une conductivité de l'unité de charge (55) est plus élevée au cours de la seconde phase du signal de réinitialisation qu'au cours de la première phase du signal de réinitialisation, moyennant quoi ladite rétroaction positive est plus élevée au cours de la seconde phase du signal de réinitialisation qu'au cours de la première phase du signal de réinitialisation.

2. Circuit comparateur verrouillé (1) selon la revendication 1, dans lequel le montage de circuits de réinitialisation est un dispositif de commutation de réinitialisation (50) connecté de manière fonctionnelle entre les première et seconde bornes de sortie (20a, 20b), dans lequel le dispositif de commutation de réinitialisation (50) est agencé de manière à être fermé au cours de la première phase du signal de réinitialisation et ouvert au cours d'une seconde phase du signal de réinitialisation.

3. Circuit comparateur verrouillé (1) selon la revendication 1 ou 2, dans lequel l'unité de charge (55) comprend :
- un premier circuit de charge (60a) connecté de manière fonctionnelle entre un premier transistor (30a) de la paire de transistors à couplage transversal et un noeud de référence ; et
- un second circuit de charge (60b) connecté de manière fonctionnelle entre un second transistor (30b) de la paire de transistors à couplage transversal et le noeud de référence ; et
dans lequel le circuit de polarisation (70) est agencé de manière à polariser les premier et second circuits de charge (60a, 60b), de sorte qu'une conductivité du premier circuit de charge (60a) et une conductivité du second circuit de charge (60b) sont plus élevées au cours de la seconde phase du signal de réinitialisation qu'au cours de la première phase du signal de réinitialisation.

4. Circuit comparateur verrouillé (1) selon la revendication 3, dans lequel les premier et second transistors (30a, 30b) de la paire à couplage transversal sont des transistors MOS du même type.

5. Circuit comparateur verrouillé (1) selon la revendication 4, dans lequel :
- le premier circuit de charge (60a) comprend un premier transistor de charge (120a) du même type que le premier transistor (30a) de la paire à couplage transversal, dans lequel la borne de drain du premier transistor de charge (120a) est connectée de manière fonctionnelle à la borne source du premier transistor (30a) de la paire à couplage transversal, la borne source du premier transistor de charge (120a) est connectée de manière fonctionnelle au noeud de référence, et la borne de grille du premier transistor de charge (120a) est agencée de manière à recevoir une tension de polarisation ; et
- le second circuit de charge (60b) comprend un second transistor de charge (120b) du même type que le second transistor (30b) de la paire à couplage transversal, dans lequel la borne de drain du second transistor de charge (120b) est connectée de manière fonctionnelle à la borne source du second transistor (30b) de la paire à couplage transversal, la borne source du second transistor de charge (120b) est connectée de manière fonctionnelle au noeud de référence, et la borne de grille du second transistor de charge (120b) est agencé de manière à recevoir une tension de polarisation.

6. Circuit comparateur verrouillé (1) selon la revendication 5, dans lequel le circuit de polarisation (70) comprend :
- un premier transistor MOS (130) de type opposé aux premier et second transistors de charge (120a, 120b), dans lequel le premier transistor MOS (130) est agencé de manière à être polarisé avec une tension en c.c. sur sa borne de grille ;
- un transistor de génération de tension de polarisation (140) du même type que les premier et second transistors de charge (120a, 120b), dans lequel la borne de grille du transistor de génération de tension de polarisation (140) est connectée de manière fonctionnelle à la borne de drain du premier transistor MOS (130) et la borne source du transistor de génération de tension de polarisation (140) est connectée de manière fonctionnelle au noeud de référence ; et
- un dispositif de commutation (150) connecté de manière fonctionnelle entre les bornes de drain et de grille du transistor de génération de tension de polarisation, dans lequel le dispositif de commutation (150) est agencé de manière à être fermé au cours de la première phase du signal de réinitialisation et ouvert au cours de la seconde phase du signal de réinitialisation ;
dans lequel le circuit de polarisation (70) est agencé de manière à générer la tension de polarisation pour les premier et second transistors de charge (120a, 120b) sur la borne de grille du transistor de génération de tension de polarisation (140).

7. Circuit comparateur verrouillé selon la revendication 1 ou 2, dans lequel l'unité de charge (55) comprend :
- un premier élément de charge (200a) connecté de manière fonctionnelle à un premier transistor (30a) de la paire de transistors à couplage transversal avec une première borne du premier élément de charge (200a) et à un noeud de référence avec une seconde borne du premier élément de charge (200a) ;
- un deuxième élément de charge (200b) connecté de manière fonctionnelle à un second transistor (30b) de la paire de transistors à couplage transversal avec une première borne du deuxième élément de charge (200b) et au noeud de référence avec une seconde borne du deuxième élément de charge (200b) ; et
- un troisième élément de charge (210) connecté de manière fonctionnelle entre la première borne du premier élément de charge (200a) et la première borne du deuxième élément de charge (200b) ; et
dans lequel le circuit de polarisation (70) est agencé de manière à polariser le troisième élément de charge (210), de sorte qu'une conductivité du troisième élément de charge (210) est plus élevée au cours de la seconde phase du signal de réinitialisation qu'au cours de la première phase du signal de réinitialisation.

8. Circuit comparateur verrouillé (1) selon la revendication 7, dans lequel le troisième élément de charge (210) comprend un transistor MOS (310) agencé de manière à recevoir une tension de polarisation en provenance du circuit de polarisation (70) sur sa borne de grille.

9. Circuit comparateur verrouillé (1) selon la revendication 8, dans lequel le circuit de polarisation (70) comprend :
- un premier transistor MOS (130) de type opposé au transistor MOS (310) du troisième élément de charge (210), dans lequel le premier transistor MOS (130) est agencé de manière à être polarisé avec une tension en c.c. sur sa borne de grille ;
- un transistor de génération de tension de polarisation (140) du même type que le transistor MOS (310) du troisième élément de charge, dans lequel la borne de grille du transistor de génération de tension de polarisation (140) est connectée de manière fonctionnelle à la borne de drain du premier transistor MOS (130) et la borne source du transistor de génération de tension de polarisation (140) est connectée de manière fonctionnelle à un noeud de référence ; et
- un dispositif de commutation (150) connecté de manière fonctionnelle entre les bornes de drain et de grille du transistor de génération de tension de polarisation, dans lequel le dispositif de commutation (150) est agencé de manière à être fermé au cours de la première phase du signal de réinitialisation et ouvert au cours de la seconde phase du signal de réinitialisation ;
dans lequel le circuit de polarisation (70) est agencé de manière à générer la tension de polarisation pour le transistor MOS (310) du troisième élément de charge (210) sur la borne de grille du transistor de génération de tension de polarisation (140).

10. Circuit électronique (400) comprenant un circuit comparateur verrouillé (1) selon l'une quelconque des revendications précédentes.

11. Circuit électronique (400) selon la revendication 10, dans lequel le circuit comparateur verrouillé (1) est agencé de manière à générer un signal de sortie différentiel du circuit comparateur verrouillé (1) sur les première et seconde bornes de sortie (20a, 20b) du circuit comparateur verrouillé (1).

12. Circuit électronique (400) selon la revendication 10, dans lequel le circuit comparateur verrouillé (1) est agencé de manière à générer un signal de sortie unidirectionnel du circuit comparateur verrouillé (1) sur l'une des première et seconde bornes de sortie (20a, 20b) du circuit comparateur verrouillé (1).

13. Circuit électronique (400) selon l'une quelconque des revendications 10 à 12, dans lequel le circuit électronique est un convertisseur analogique à numérique ou un circuit de mémoire.

14. Circuit intégré (500) comprenant un circuit comparateur verrouillé (1) selon l'une quelconque des revendications 1 à 9.

15. Dispositif électronique (510) comprenant un circuit comparateur verrouillé (1) selon l'une quelconque des revendications 1 à 9.

16. Dispositif électronique (510) selon la revendication 15, dans lequel le dispositif électronique (510) est un récepteur de télévision, un écran à cristaux liquides, un écran d'ordinateur, une caméra numérique, un projecteur ou un récepteur radio.
